Europäisches Patentamt

European Patent Office

Office européen des brevets

(11) Numéro de publication : **0 421 896 B1**

(12) **FASCICULE DE BREVET EUROPEEN**

(45) Date de publication du fascicule du brevet :
**11.01.95 Bulletin 95/02**

(51) Int. Cl.$^6$ : **H03M 1/14, H03M 1/36**

(21) Numéro de dépôt : **90420423.7**

(22) Date de dépôt : **01.10.90**

(54) **Convertisseur analogique/numérique à haute fréquence de conversion.**

(30) Priorité : **02.10.89 FR 8913048**

(43) Date de publication de la demande :
**10.04.91 Bulletin 91/15**

(45) Mention de la délivrance du brevet :
**11.01.95 Bulletin 95/02**

(84) Etats contractants désignés :
**DE FR GB IT NL**

(56) Documents cités :
**GB-A- 2 190 258**
**1988 IEEE SOLID-STATE CIRCUITS CONFE-RENCE, vol. 31, 17 - 19 février 1988, pages220-221,376, IEEE, New York, US; T. MATSUURA et al.: "An 8b 20MHz CMOS half-flash A/D converter"**

(73) Titulaire : **FRANCE TELECOM**
**6, Place d'Alleray**
**F-75015 Paris (FR)**

(72) Inventeur : **Senn, Patrice**
**13, Grande Rue**
**F-38000 Grenoble (FR)**
Inventeur : **Abrial, André**
**Lotissement "Les Jonquilles" No. 15**
**F-38420 Le Versoud (FR)**

(74) Mandataire : **de Beaumont, Michel**
**1bis, rue Champollion**
**F-38000 Grenoble (FR)**

EP 0 421 896 B1

## Description

La présente invention concerne des convertisseurs analogique/numérique à haute fréquence de conversion, et plus particulièrement de tels convertisseurs utilisables dans le domaine vidéo.

On connaît des convertisseurs appelés convertisseurs "flash" qui comprennent un diviseur de tension constitué par exemple par un réseau résistif fournissant $2^N$ tensions de référence étagées. Pour convertir un signal analogique en mot de N bits, ils comportent $2^N$ comparateurs dont chacun compare le signal analogique à l'une des tensions de référence. Les sorties des comparateurs sont connectées à un dispositif de codage destiné à fournir les N bits du mot logique. Tous les comparateurs sont commandés en parallèle à chaque cycle d'horloge et la fréquence de conversion est égale à la fréquence de l'horloge. Cependant, un tel nombre de comparateurs occupe une surface de circuit importante et entraîne une forte consommation.

Pour réduire ce nombre de comparateurs, on a prévu des convertisseurs appelés convertisseurs "demi-flash", voir la publication intitulée "An 8b 20 MHz CMOS Half-Flash AID Converter" par T. MATSUURA et al., dans "1988 IEEE International SOLID-STATE CIRCUITS CONFERENCE, vol. 31, 17-19 février 1988, pages 220-221, 376". Des signaux analogiques sont convertis en mots logiques composés de P bits de poids fort et Q bits de poids faible (P + Q = N). Les convertisseurs "demi-flash" comprennent $2^P$ comparateurs dits comparateurs de poids fort pour fournir après codage, au cours d'une première période d'horloge, les bits de poids fort et $2^Q$ comparateurs dits comparateurs de poids faible pour fournir après codage, au cours de la période d'horloge suivante, les bits de poids faible.

Mais de tels convertisseurs "demi-flash" ont une fréquence de conversion deux fois moins importante que celle des convertisseurs "flash". En outre, ils comprennent des moyens de conservation de la tension d'entrée analogique sur deux périodes d'horloge comme par exemple des échantillonneurs-bloqueurs.

Ainsi, un objet de la présente invention est de prévoir un convertisseur analogique/numérique de type "demi-flash" fonctionnant à haute fréquence de conversion.

Un autre objet de la présente invention est de prévoir un tel convertisseur simplifié n'utilisant aucun moyen de conservation du signal d'entrée analogique.

Pour atteindre ces objets, la présente invention prévoit un convertisseur analogique/numérique recevant des signaux analogiques sur une borne d'entrée et fournissant des mots logiques composés de P bits de poids fort et Q bits de poids faible. Ce convertisseur analogique/numérique comprend :

un diviseur délivrant sur des premières sorties

$2^P$ tensions principales séparées par des échelons réguliers, chaque échelon étant partagé en $2^Q+1$ sous-échelons égaux, et délivrant sur des deuxièmes sorties, pour chaque échelon, $2^Q$ tensions secondaires entre chaque paire de sous-échelons,

$2^P$ comparateurs de poids fort ayant chacun une première entrée connectée à la borne d'entrée, une deuxième entrée reliée à une première sortie distincte et une sortie connectée à un premier dispositif de codage qui est relié en sortie à P bornes de sortie de bits de poids fort,

$2^Q$ comparateurs de poids faible ayant chacun une première entrée connectée à la borne d'entrée et une sortie connectée à un deuxième dispositif de codage qui est relié en sortie à Q bornes de sortie de bits de poids faible,

un sélecteur connecté, d'une part, à une deuxième entrée de chacun des comparateurs de poids faible, d'autre part, aux deuxièmes sorties associées à chaque échelon, et

une horloge produisant un signal ayant un premier et un deuxième niveau à chaque période.

Les comparateurs de poids fort ont leurs deuxièmes entrées validées sur le premier niveau du signal d'horloge pour une initialisation sur les tensions principales et leurs premières entrées validées sur le deuxième niveau du signal d'horloge pour une comparaison par rapport à la tension d'entrée analogique et pour déterminer un échelon.

Le premier dispositif de codage comprend des moyens de commande du sélecteur pour établir, à l'issue de chaque comparaison des comparateurs de poids fort, une liaison entre les $2^Q$ deuxièmes entrées des comparateurs de poids faible et les $2^Q$ deuxièmes sorties associées à l'échelon déterminé.

Les comparateurs de poids faible ont leurs premières entrées validées sur le deuxième niveau du signal d'horloge pour une initialisation sur la tension d'entrée analogique et leurs deuxièmes entrées validées sur le premier niveau du signal d'horloge pour une comparaison par rapport aux tensions secondaires.

Ces objets, caractéristiques et avantages ainsi que d'autres de la présente invention seront exposés plus en détail dans la description suivante d'un mode de réalisation particulier faite en relation avec les figures jointes parmi lesquelles :

la figure 1 représente de façon schématique un convertisseur analogique/numérique ;

la figure 2 représente schématiquement un exemple de comparateur à auto-zéro utilisable dans un convertisseur analogique/numérique ;

la figure 3 représente schématiquement un comparateur à auto-zéro utilisé en tant que comparateur de poids fort ; et

la figure 4 représente un comparateur à auto-zéro utilisé en tant que comparateur de poids faible.

Pour une plus grande clarté, il est décrit un mode de réalisation d'un convertisseur analogique/numérique qui convertit des signaux analogiques en mots de 4 bits composés de P = 2 bits de poids fort et Q = 2 bits de poids faible. Il est cependant tout à fait possible de réaliser des convertisseurs analogique/numérique plus importants du même type fournissant par exemple des mots logiques de 8, 16 ou 32 bits.

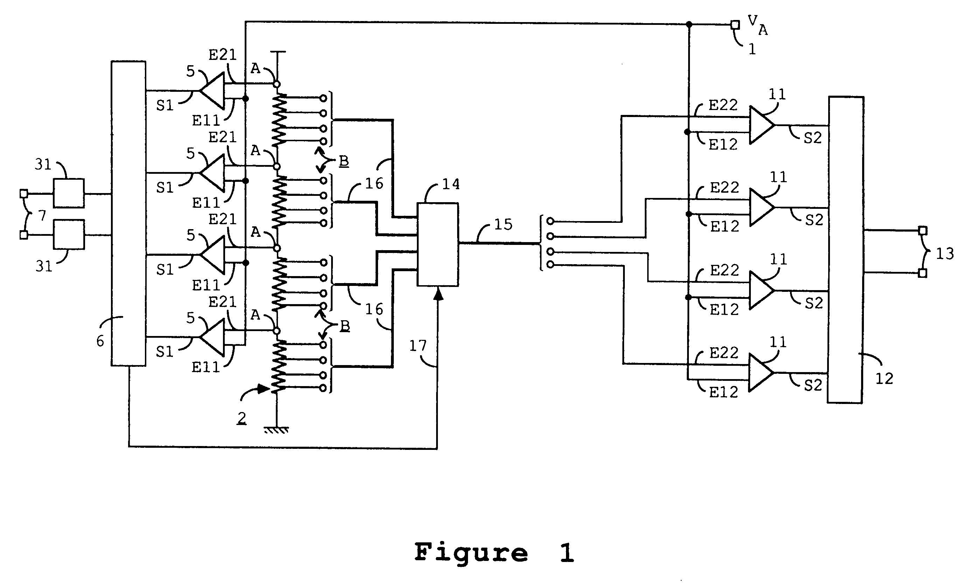

La figure 1 représente un convertisseur analogique/numérique qui reçoit des signaux analogiques ($V_A$) sur une borne d'entrée 1. Un diviseur de tension 2 fournit sur des sorties A quatre tensions principales de référence $V_p$ séparées par des échelons réguliers. Chaque échelon est partagé en cinq sous-échelons égaux. Le diviseur fournit ainsi également, pour chaque tension principale, quatre tensions secondaires de référence $V_S$ correspondant chacune à une valeur de tension entre une paire de sous-échelons. Au total, seize tensions secondaires de référence sont disponibles sur des sorties B du diviseur.

Quatre comparateurs de poids fort 5 ont chacun une première entrée E11 connectée à la borne d'entrée 1 et une deuxième entrée E21 à une sortie A distincte. Ils ont également une sortie S1 connectée à un premier dispositif de codage 6 qui est relié en sortie à deux bornes de sortie de bits de poids fort 7.

Quatre comparateurs de poids faible 11 ont chacun une première entrée E12 connectée à la borne d'entrée 1 et une sortie S2 connectée à un deuxième dispositif de codage 12 qui est relié en sortie à deux bornes de sortie de bits de poids faible 13. La deuxième entrée E22 de chacun de ces comparateurs est reliée à un sélecteur 14 par l'intermédiaire d'un câble à quatre connexions 15. Ce sélecteur est aussi relié à chaque ensemble de sorties secondaires B associé à un échelon par un câble à quatre connexions 16.

Le dispositif de codage 6 comprend des moyens de commande reliés à une entrée de commande 17 du sélecteur. La commande du sélecteur sera précisée ci-après.

Le convertisseur comprend en outre une horloge (non représentée) dont le signal comporte à chaque période un niveau haut et un niveau bas.

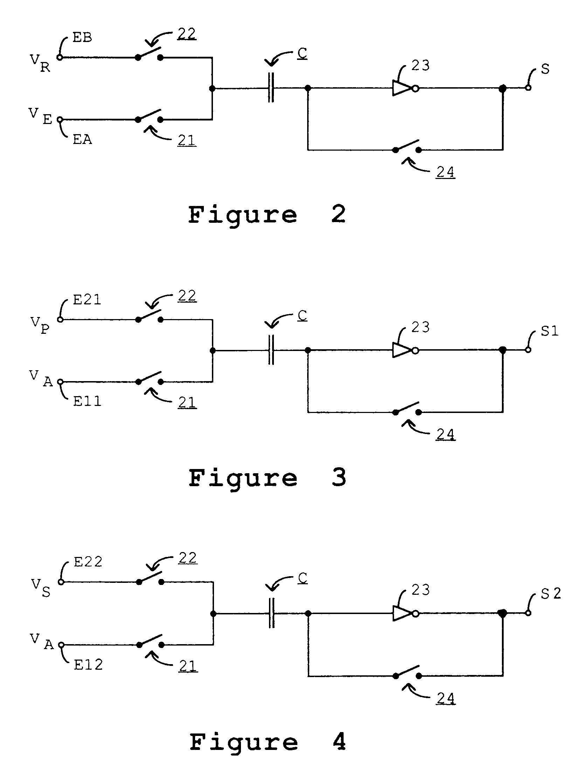

La figure 2 représente schématiquement un comparateur à auto-zéro classique. Ce type de comparateur peut être utilisé aussi bien pour des comparateurs de poids fort que pour des comparateurs de poids faible.

Il comprend une capacité C dont une borne est reliée à la première entrée, désignée ici de façon générale par EA, du comparateur par un interrupteur 21 et à la deuxième entrée EB par un interrupteur 22. La deuxième borne de la capacité est connectée à l'entrée d'un inverseur 23 dont la sortie constitue la sortie S du comparateur. Un interrupteur supplémentaire 24 est monté en parallèle aux bornes de l'inverseur.

Pour comparer une tension $V_E$ appliquée sur l'entrée EA à une tension de référence $V_R$ appliquée sur l'entrée EB, les comparateurs à auto-zéro fonctionnent de la façon suivante. Dans une première phase appelée phase d'initialisation, l'interrupteur 21 est ouvert et les interrupteurs 22 et 24 sont fermés. L'inverseur est bouclé sur lui-même et sa tension d'entrée est égale à sa tension de seuil de basculement $V_o$. La charge Q de la capacité est donnée par $Q = C (V_o-V_R)$.

Dans une deuxième phase appelée phase de comparaison, l'interrupteur 21 est fermé et les interrupteurs 22 et 24 sont ouverts. L'inverseur a une impédance d'entrée très élevée, et la charge de la capacité est conservée. Ainsi, la nouvelle tension d'entrée $V_0{}^1$ de l'inverseur est reliée à la tension $V_o$ par la relation

$$V_0{}^1 - V_E = V_o - V_R$$

ou encore

$$V_o{}^1 = V_o - (V_R - V_E)$$

On s'affranchit ainsi dans les comparateurs à auto-zéro des tensions parasites constantes.

La figure 3 représente un tel comparateur à auto-zéro utilisé en tant que comparateur de poids fort. Les entrées sont alors désignées par les références E11 et E21 comme sur la figure 1 et elles reçoivent la tension d'entrée analogique $V_A$ et une des tensions principales de référence $V_p$, respectivement. La sortie est désignée par S1.

Les interrupteurs 22 et 24 sont commandés par le signal d'horloge. Ils sont fermés lorsque le signal d'horloge est à son niveau haut et ouverts sur les niveaux bas. Par contre, l'interrupteur 21 est commandé par le signal d'horloge inverse, c'est-à-dire qu'il est fermé lorsque le signal inverse est à son niveau haut et ouvert sur les niveaux bas.

Les comparateurs de poids fort sont ainsi dans un état d'initialisation par rapport aux tensions principales de référence $V_P$ lorsque le signal d'horloge est à un niveau haut, et dans un état de comparaison en lisant la tension d'entrée analogique $V_A$ lorsque le signal d'horloge inverse est à un niveau haut.

De préférence, les passages de niveau haut à niveau bas des signaux d'horloge et de niveau bas à niveau haut des signaux d'horloge inverses sont sans recouvrement et séparés d'un petit intervalle de temps.

A la fin de chaque phase de comparaison des comparateurs de poids fort, une des tensions principales $V_P$ qui correspond à un échelon particulier est déterminée. Le dispositif de codage délivre les bits de poids fort sur les bornes de sortie 7.

La figure 4 représente un comparateur à auto-zéro utilisé en tant que comparateur de poids faible. Les entrées E12 et E22 reçoivent la tension d'entrée analogique $V_A$ et une des tensions secondaires de référence $V_S$, respectivement.

L'interrupteur 22 est synchronisé sur le signal d'horloge et les interrupteurs 21 et 24 sur le signal d'horloge inverse. Quand le signal d'horloge inverse est haut, les interrupteurs 21 et 24 sont fermés et l'interrupteur 22 est ouvert. Ainsi, tandis que les comparateurs de poids fort sont dans un état de comparaison et lisent la tension d'entrée analogique $V_A$, les comparateurs de poids faible sont dans un état d'initialisation sur cette même tension d'entrée $V_A$.

Lorsque les comparateurs de poids fort terminent leurs comparaisons et qu'un échelon particulier est déterminé, le dispositif de codage 6 commande de sélecteur 14 pour établir une liaison entre les entrées E22 des comparateurs de poids faible et l'ensemble de sorties B associé à l'échelon déterminé.

Quand le signal d'horloge est au niveau haut, l'interrupteur 22 est fermé et les interrupteurs 21 et 24 sont ouverts. Les comparateurs de poids faible sont dans un état de comparaison par rapport aux tensions secondaires de référence $V_S$. Les signaux résultant des comparaisons sont envoyés au dispositif de codage 12 qui fournit en sortie les bits de poids faible sur les bornes de sortie 13.

Ainsi, les bits de poids fort sont fournis à la fréquence de l'horloge lorsque le signal d'horloge inverse est haut, et les bits de poids faible sont également fournis à la fréquence de l'horloge lorsque le signal d'horloge est haut. La fréquence de conversion du convertisseur est celle de l'horloge.

En outre, pour chaque conversion en mot logique, les comparateurs de poids fort et les comparateurs de poids faible lisent simultanément la tension d'entrée analogique. Il n'est ainsi plus besoin de prévoir des moyens de conservation de la tension d'entrée analogique comme des échantillonneurs-bloqueurs.

Selon une variante de la présente invention, il est prévu entre chaque borne de sortie de bits de poids fort 7 et le dispositif de codage 6 une bascule 31 utilisée pour retarder de sensiblement une demi-période la sortie des bits de poids fort de façon à fournir en même temps les bits de poids fort et les bits de poids faible.

## Revendications

1. Convertisseur analogique/numérique recevant des signaux analogiques sur une borne d'entrée (1) et fournissant des mots logiques composés de P bits de poids fort et Q bits de poids faible, comprenant :

   un diviseur (2) délivrant sur des premières sorties (A) $2^P$ tensions principales séparées par des échelons réguliers, chaque échelon étant partagé en $2^Q+1$ sous-échelons égaux, et délivrant sur des deuxièmes sorties (B), pour chaque échelon, $2^Q$ tensions secondaires entre chaque paire de sous-échelons,

   $2^P$ comparateurs de poids fort (5) ayant chacun une première entrée (E11) connectée à la borne d'entrée, une deuxième entrée (E21) reliée à une première sortie distincte et une sortie (S1) connectée à un premier dispositif de codage (6) qui est relié en sortie à P bornes de sortie de bits de poids fort (7),

   $2^Q$ comparateurs de poids faible (11) ayant chacun une première entrée (E12) connectée à la borne d'entrée et une sortie (S2) connectée à un deuxième dispositif de codage (12) qui est relié en sortie à Q bornes de sortie de bits de poids faible (13),

   un sélecteur (14) connecté, d'une part, à une deuxième entrée (E22) de chacun des comparateurs de poids faible, d'autre part, aux deuxièmes sorties associées à chaque échelon,

   une horloge produisant un signal ayant un premier et un deuxième niveau à chaque période,

   les comparateurs de poids fort ayant leurs deuxièmes entrées validées sur le premier niveau du signal d'horloge pour une initialisation sur les tensions principales et leurs premières entrées validées sur le deuxième niveau du signal d'horloge pour une comparaison par rapport à la tension d'entrée analogique et pour déterminer un échelon,

   le premier dispositif de codage comprenant des moyens de commande du sélecteur pour établir, à l'issue de chaque comparaison des comparateurs de poids fort, une liaison entre les $2^Q$ deuxièmes entrées des comparateurs de poids faible et les $2^Q$ deuxièmes sorties associées à l'échelon déterminé,

   caractérisé en ce que les comparateurs de poids faible ont leurs premières entrées validées sur le deuxième niveau du signal d'horloge pour une initialisation sur la tension d'entrée analogique et leurs deuxièmes entrées validées sur le premier niveau du signal d'horloge pour une comparaison par rapport aux tensions secondaires.

2. Convertisseur analogique/numérique selon la revendication 1, caractérisé en ce que les comparateurs de poids fort et les comparateurs de poids faible sont des comparateurs à auto-zéro.

3. Convertisseur analogique/numérique selon la revendication 1, caractérisé en ce qu'il comprend en outre une bascule (31) entre chaque borne de sortie de bits de poids fort (7) et le premier dispositif de codage (6).

## Patentansprüche

1. Analog-Digitalwandler, der analoge Signale an einem Eingangsanschluß (11) empfängt und logische Worte aus P Bits mit hohem Rang und Q Bits mit niedrigem Rang abgibt, mit:

einem Teiler, der an ersten Ausgängen (A) $2^P$ Hauptspannungen abgibt, die durch regelmäßige Stufen getrennt sind, wobei jede Stufe in $2^Q+1$ gleiche Unterstufen unterteilt ist, und der über zweite Ausgänge (B) für jede Stufe $2^Q$ Nebenspannungen zwischen jedem Paar von Unterstufen abgibt,

$2^P$ Vergleicher mit hohem Rang (5), die jeweils einen ersten, mit dem Eingangsanschluß verbundenen Eingang (E11), einen zweiten, an einen ersten eigenen Ausgang angeschlossenen Eingang (E21) und einen Ausgang (1) aufweisen, der mit einer ersten Codiereinrichtung (6) verbunden ist, welche am Ausgang an P Ausgangsanschlüsse (7) für Bits mit hohem Rang angeschlossen ist,

$2^Q$ Vergleicher mit niedrigem Rang (11), die jeweils einen ersten, mit dem Eingangsanschluß verbundenen Eingang (E12) und einen Ausgang (S2) aufweisen, der mit einer zweiten Codiereinrichtung (12) verbunden ist, welche am Ausgang an Q Ausgangsanschlüsse (13) für Bits mit niedrigem Rang angeschlossen ist,

eine Wahlschaltung (14), die einerseits mit einem zweiten Eingang (E22) eines jeden Vergleichers mit niedrigem Rang und andererseits an die zweiten Ausgänge, die jeder Stufe zugeordnet sind, verbunden ist,

einen Taktgenerator, der ein Signal mit einem ersten und einem zweiten Pegel in jeder Periode erzeugt,

wobei die zweiten Eingänge der Vergleicher mit hohem Rang beim ersten Pegel des Taktsignales für eine Initialisierung auf die Hauptspannungen und deren erste Eingänge bei dem zweiten Pegel des Taktsignales für einen Vergleich in bezug auf die analoge Eingangsspannung und zum Bestimmen einer Stufe aktiviert sind,

wobei die erste Codiereinrichtung Steuermittel für die Wahlschaltung aufweist, um bei der Ausgabe eines jeden Vergleiches der Vergleicher mit hohem Rang eine Verbindung zwischen den $2^Q$ zweiten Eingängen der Vergleicher mit niedrigem Rang und den $2^Q$ zweiten, der bestimmten Stufe zugeordneten Ausgängen einzurichten,

dadurch gekennzeichnet, daß die ersten Eingänge der Vergleicher mit niedrigem Rang bei dem zweiten Pegel des Taktsignales für eine Initialisierung auf die analoge Eingangsspannung und deren zweite Eingänge bei dem ersten Pegel des Taktsignales für einen Vergleich in bezug auf die Nebenspannungen aktiviert sind.

2. Analog-Digitalwandler nach Anspruch 1, dadurch gekennzeichnet, daß die Vergleicher mit hohem Rang und die Vergleicher mit niedrigem Rang Vergleicher mit automatischem Nullabgleich sind.

3. Analog-Digitalwandler nach Anspruch 1, dadurch gekennzeichnet, daß er ferner ein Flipflop (31) zwischen jedem Augangsanschluß für Bits mit hohem Rang (7) und der ersten Codiereinrichtung (6) aufweist.

**Claims**

1. An analog/digital converter receiving analog signals at an input terminal (1) and supplying logic words constituted by P high order bits and Q low order bits, comprising:

a divider (2) supplying on first outputs (A) $2^P$ main voltages separated by regular steps, each step being shared into $2^Q+1$ equal substeps, and supplying on second outputs (B), for each step, $2^Q$ secondary voltages between each sub-step pair,

$2^P$ high weight comparators (5), each of which has a first input (E11) connected to said input terminal, a second input (E21) connected to a first distinct output, and an output (S1) connected to a first coding device (6) which is coupled to P high order bit output terminals (7),

$2^Q$ low weight comparators (11), each of which has a first input (E12) connected to said input terminal and an output (S2) connected to a second coding device (12) which is coupled to Q low order bit output terminals (13),

a selector (14) connected, on the one hand, to a second input (E22) of each of the low weight comparators and, on the other hand, to the second outputs associated with each step,

a clock having a first and a second level at each period,

said high weight comparators having their second inputs enabled by the first level of the clock signal for initialization on the main voltages and their first inputs enabled by the second level of the clock signal for comparison with the analog input voltage and for determining a step,

said first coding device comprising means for controlling said selector in order to establish, at the end of each comparison of high weight comparators, a connection between the $2^Q$ second inputs of said low weight comparators and the $2^Q$ second outputs associated with the determined step,

characterized in that said low weight comparators have their first inputs enabled by the second level of the clock signal for initialization on the analog input voltage and their second inputs enabled by the first level of the clock signal for comparison with the secondary voltages.

2. An analog/digital converter according to claim 1, characterized in that said high weight comparators and low weight comparators are auto-zero comparators.

3. An analog/digital converter according to claim 1, characterized in that it further comprises a flip-flop (31) between each high order bit output terminal (7) and said first coding device (6).

Figure 1

EP 0 421 896 B1

**Figure 2**

**Figure 3**

**Figure 4**